(19) Europäisches Patentamt
European Patent Office
Office européen des brevets

(11) **EP 2 486 656 B1**

(12) **FASCICULE DE BREVET EUROPEEN**

(45) Date de publication et mention
de la délivrance du brevet:
**10.08.2016 Bulletin 2016/32**

(51) Int Cl.:
*H03H 9/02* *(2006.01)*      *H03H 9/205* *(2006.01)*
*H03H 9/25* *(2006.01)*      *H03H 9/54* *(2006.01)*
*H03H 9/58* *(2006.01)*      *H04B 1/59* *(2006.01)*
*H03H 9/64* *(2006.01)*      *G06K 19/067* *(2006.01)*

(21) Numéro de dépôt: **10762701.0**

(22) Date de dépôt: **08.10.2010**

(86) Numéro de dépôt international:
**PCT/EP2010/065143**

(87) Numéro de publication internationale:
**WO 2011/042557 (14.04.2011 Gazette 2011/15)**

(54) **TRANSPONDEUR À MODES RÉSONANTS COUPLÉS INTÉGRANT UNE CHARGE VARIABLE**

TRANSPONDER MIT VERKOPPELTEN RESONANTEN MODEN AN EINER VARIABLEN ABSCHLUSSLAST

TRANSPONDER USING COUPLED RESONANT MODES WITH A VARIABLE LOAD

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **09.10.2009 FR 0904844**

(43) Date de publication de la demande:
**15.08.2012 Bulletin 2012/33**

(73) Titulaires:
• **Senseor**
**06250 Mougins (FR)**
• **Centre National de la Recherche Scientifique**
**75016 Paris (FR)**
• **Université de Franche-Comté**
**25000 Besançon (FR)**

(72) Inventeurs:
• **BALLANDRAS, Sylvain**
**F-25000 Besançon (FR)**
• **DANIAU, William**
**F-25000 Montfaucon (FR)**
• **LEGUEN, Jean-François**
**F-06560 Valbonne (FR)**

(74) Mandataire: **Esselin, Sophie
Marks & Clerk France
Conseils en Propriété Industrielle
Immeuble Visium
22 Avenue Aristide Briand
94117 Arcueil Cedex (FR)**

(56) Documents cités:
**EP-A1- 0 487 783      EP-A1- 2 051 377
WO-A1-96/33423      DE-A1- 19 634 621
US-A1- 2003 127 944      US-A1- 2004 159 154
US-A1- 2006 091 978      US-A1- 2007 139 165
US-A1- 2008 303 650**

• **WALDEMAR SOLUCH: "Surface Acoustic Wave
Two Resonator Filter Using Synchronous
Coupling Interdigital Transducers", IEEE
TRANSACTIONS ON ULTRASONICS,
FERROELECTRICS AND FREQUENCY
CONTROL, IEEE, US LNKD-
DOI:10.1109/58.585221, vol. 44, no. 1, 1 janvier
1997 (1997-01-01), pages 218-219, XP011062819,
ISSN: 0885-3010**

**Description**

Le domaine de l'invention est celui des transpondeurs à résonateurs à ondes acoustiques, interrogeables à distance.

Dans le domaine des transpondeurs passifs interrogeables à distance, on peut actuellement avoir recours à des lignes à retard réalisées sur niobate de lithium et fonctionnant dans leur version sans fil (wireless) dans la bande ISM centrée en 2,45 GHz (imposé par le besoin de bande nécessaire à la fonction spectrale associée) à partir d'électrodes générant des ondes acoustiques.

Ce type de transpondeur peut notamment être utilisé pour de la détection de variations de paramètres physiques tels que la pression, la température,...

Ceci pose la difficulté de réaliser des dispositifs technologiques délicats par les dimensions des peignes d'électrodes des transducteurs (0,4 $\mu$m typiquement, soit une longueur d'onde de 1,6 $\mu$m pour des vitesses de propagation de 3500 à 3800 m.s$^{-1}$). Ces dispositifs doivent être réalisés sur niobate de lithium pour obtenir des couplages électromécaniques compatibles avec le mode d'interrogation correspondant (Ks$^2$ au moins égal à 5%). Ces structures présentent donc de fortes dérives en température qui peuvent poser problème dans certains cas.

De plus, pour réaliser les retards idoines (c'est à dire compatibles avec la largeur de bande autorisée), ces lignes à retard présentent des dimensions de l'ordre de 6 à 10 mm hors encapsulation, pouvant s'avérer critique pour des applications réclamant des capteurs de petite dimension.

Ainsi pour une application de ce principe à plus basses fréquences, l'analyse pouvant être considérée purement linéaire en première approximation, les dimensions correspondantes sont en fonction du rapport d'échelle de fréquence. Et pour une application de ligne à retard réflective à 434 MHz, la distance nécessaire à engendrer les retards recherchés est de l'ordre de 6 fois celle à 2,45 GHz.

Par ailleurs, la bande autorisée pour émission à 434 MHz est relativement huit fois plus étroite, imposant de fait des distances de propagation encore plus grande.

Il a déjà également été proposé des dispositifs à 2,45 GHz utilisés comme transpondeur et comprenant un transducteur large bande émettant des ondes de surface de Rayleigh. Celles-ci se réfléchissent sur des réseaux réflecteurs et sont détectées par le transducteur émetteur, renvoyant ainsi un signal de type code-barre (la présence d'un groupe réflecteur correspondant au 1 logique, son absence à 0). Cette réponse peut être modulée en intensité en connectant une charge de propriétés électriques variables.

Une autre approche (voir DE19634621) peut également consister à utiliser deux résonateurs indépendants, dont l'un voit ses propriétés modulées par une charge connectée en parallèle ou en série. Cette dernière approche est toutefois délicate à mettre effectivement en oeuvre dans la mesure où quelle que soit l'association électrique adoptée, la charge influe inévitablement sur l'un comme sur l'autre des résonateurs formant le capteur/transpondeur (on ne peut vraisemblablement pas envisager une mesure avec un simple résonateur perturbé par la charge, la mesure nécessitant toujours une référence destinée à éliminer les sources de perturbation corrélées).

L'invention propose à cet effet une solution permettant notamment d'identifier de manière fiable le fait qu'un transpondeur est en mode ON ou en mode OFF, par suivi de l'analyse de pics de résonance et non plus par simple absence ou présence de pics de résonance comme proposé dans l'art connu.

Plus précisément, la présente invention a pour objet transpondeur comportant au moins un premier résonateur et un second résonateur ou une série de seconds résonateurs à couplage d'ondes évanescentes présentant au moins un premier mode et un second mode résonants, lesdits premier et second(s) résonateurs étant couplés par une zone étroite au sein de laquelle le recouvrement d'ondes évanescentes des champs émis par les premier et second(s) résonateurs peut s'établir, créant ainsi des conditions de couplage de mode, ledit premier résonateur étant connecté via un premier port, à un premier moyen permettant une interrogation (antenne, voie filaire) caractérisé en ce que ledit ou lesdits seconds résonateurs sont connectés via au moins un second port, à au moins un élément de charge variable ($E_{CV}$) capable de modifier les conditions de couplage des modes résonants et par voie de conséquence la réponse mesurée sur ledit premier port.

Selon une variante de l'invention, le transpondeur comporte au moins une structure de résonateurs à ondes acoustiques de surface.

Selon une variante de l'invention, la structure de résonateurs comporte au moins un premier transducteur positionné entre un premier réflecteur et un réflecteur central, un second transducteur positionné entre ledit réflecteur central et un second réflecteur, le long d'un axe longitudinal, de manière à créer des modes acoustiques résonants couplés longitudinaux dont le vecteur propagation est perpendiculaire audit axe longitudinal.

Les périodes des transducteurs et des réflecteurs sont choisies de sorte que les ondes sous les réseaux réflecteurs présentent un caractère évanescent.

Avantageusement, on choisit les périodes des réflecteurs de sorte que la partie imaginaire du nombre d'onde normalisé correspondant coïncidant avec la fréquence de synchronisme des transducteurs soit maximale.

Selon une variante de l'invention, la structure de résonateurs est de type symétrique comportant au moins un premier transducteur central et un second transducteur scindé en deux parties positionnées de part et d'autre du premier transducteur, lesdits transducteurs étant situés entre des réflecteurs.

Selon une variante de l'invention, la structure de résonateurs est réalisée à la surface d'un substrat de type quartz ou de type niobate de lithium ou de type tantalate de lithium.

Selon une variante de l'invention, la structure de résonateurs comporte :

- une première voie acoustique monomode comprenant au moins un premier transducteur positionné entre deux premiers réflecteurs,
- une seconde voie acoustique monomode comprenant au moins un second transducteur positionné entre deux seconds réflecteurs ;
- les première et seconde voies acoustiques étant couplées de manière à définir des modes acoustiques résonants transversaux se propageant dans une direction parallèle aux voies acoustiques.

Selon une variante de l'invention, la structure de résonateurs comporte :

- une première voie acoustique monomode comprenant un premier transducteur positionné entre un premier réflecteur et un premier réflecteur central, un second transducteur positionné entre ledit premier réflecteur central et un second réflecteur ;
- une seconde voie acoustique monomode comprenant un troisième transducteur positionné entre un troisième réflecteur et un second réflecteur central, un quatrième transducteur positionné entre ledit second réflecteur central et un quatrième réflecteur ;
- les première et seconde voies acoustiques étant couplées de manière à définir des modes acoustiques résonants transversaux se propageant dans une direction parallèle aux voies acoustiques.

De tels résonateurs peuvent être synchrones, de structure dite HicCup, asynchrones, etc... Ils sont séparés par un bus correspondant à une électrode pleine sous laquelle les ondes se propagent à une vitesse de phase supérieure à celle sous le réseau, créant les conditions idoines de couplage par ondes évanescentes. Ce type de couplage ainsi que le couplage longitudinal est décrit notamment dans l'article de William Steichen, Sylvain Ballandras, « Composants acoustique utilisés pour le filtrage : revue des différentes technologies », Techniques de l'Ingénieur, E2000, TI Editions, 2008.

Selon une variante de l'invention, les première et seconde voies acoustiques sont réalisées sur un substrat de type quartz.

Selon une variante de l'invention, les première et seconde voies acoustiques sont réalisées sur un substrat de type quartz, pouvant être de type coupes de quartz compensées des effets de température (famille de coupes AT, etc.).

Selon une variante de l'invention, les première et seconde voies acoustiques sont réalisées sur un substrat de type tantalate de lithium ou de type matériau dont la propagation des ondes sous le réseau présente une vitesse de phase plus faible que sous les bus pour une épaisseur de métal identique.

Selon une variante de l'invention, le transpondeur comporte au moins une structure de résonateurs à ondes acoustiques de volume.

Selon une variante de l'invention, la structure est de type plaque et comporte un matériau piézoélectrique inséré entre deux premières électrodes situées dans un même plan, et une seconde électrode, la distance entre lesdites premières électrodes et la seconde électrode étant de l'ordre d'une demi-longueur d'onde acoustique $\lambda/2$ avec $\lambda$ : la longueur d'onde acoustique telle que la résonance corresponde à une vibration dont le maximum d'énergie se situe au niveau de la fibre neutre de ladite plaque, satisfaisant les conditions aux limites mécaniques. La longueur caractéristique de cette vibration, soit la distance entre deux maximums d'amplitude de vibration en phase correspond de fait à deux fois l'épaisseur de la plaque. L'épaisseur de la plaque est donc égale à la demi-longueur d'onde, de manière à définir un couplage transversal d'ondes de volume évanescente

Selon une variante de l'invention, la structure comporte un matériau piézoélectrique à la surface d'un substrat, ladite structure comportant en outre deux premières électrodes situées dans un même plan et une seconde électrode enterrée dans le matériau piézoélectrique, la distance entre lesdites premières électrodes et la surface du substrat étant de l'ordre d'une demi-longueur d'onde acoustique, de manière à définir un couplage transversal d'ondes de volume évanescentes.

Selon une variante de l'invention, la structure comporte un matériau piézoélectrique à la surface d'un substrat et aux moins une première électrode dans un premier plan, une seconde électrode dans un second plan et une troisième électrode dans un troisième plan, le premier résonateur étant défini entre les première et seconde électrodes, le second résonateur étant défini entre les seconde et troisième électrodes de manière à définir un couplage longitudinal d'ondes de volume évanescentes, la structure comportant l'empilement de deux structures de résonateurs comportant deux plaques ou films de matériau piézoélectrique.

Selon une variante de l'invention, le matériau piézoélectrique est de type niobate de lithium ou tantalate de lithium.

De même que pour les ondes de surface, on peut envisager de multiplier les éléments résonants et les interconnecter pour réaliser des structures variées destinées notamment à améliorer la sensibilité à la charge.

Selon une variante de l'invention, la structure comporte un matériau piézoélectrique enserré par deux électrodes, la première électrode étant chargée par un miroir de Bragg (obtenu par un empilement de couches d'impédances acoustiques notablement différentes d'un quart de longueur d'onde d'épaisseur), un deuxième matériau piézoélectrique enserré par deux électrodes dont l'une est chargée acoustiquement par un miroir de Bragg tel que défini plus haut, les deux structures étant reliées via un empilement fonctionnant également à la condition de Bragg mais de dimension permettant un couplage par ondes évanescentes des ondes piégées dans les deux résonateurs ainsi constitués.

L'ajout d'un miroir de Bragg en surface supérieure, permet d'envisager des modalités d'encapsulation bas coût sans nécessiter de cavité d'air comme c'est le cas habituellement pour les dispositifs acousto-électroniques.

Dans la présente invention, l'élément de charge peut être de type capacitif ou de type selfique ou de type ohmique.

Selon une variante de l'invention, le premier moyen est une antenne.

Selon une variante de l'invention, le premier moyen est filaire.

Ainsi, le transpondeur de la présente invention permet d'exploiter les bandes ISM basses (434, 866, 915 MHz) avec des résonateurs à ondes de surface ou de volume, de s'affranchir des dérives de température en exploitant des modes compensés, de fonctionner avec des composants de très petites tailles, comme les composants à ondes de volume de type « HBARs » décrits ultérieurement, et ce avec une référence intégrée.

La possibilité de fonctionner à 2,45 GHz en exploitant des modes à très fort coefficient de qualité représente également un avantage de la présente invention. En substance, les dimensions et la versatilité fréquentielle de la solution de la présente invention, rendent cette dernière particulièrement avantageuse.

La présente invention offre par ailleurs plus de modalités que les lignes à retard, dans la mesure ou un grand nombre de matériaux peuvent être exploités selon son principe (quartz, tantalate, niobate, composites à ondes de volume pour les HBARs tels que niobate/quartz, AIN/Si, ou les matériaux spécifiquement utilisés dans les résonateurs à ondes de volume à couplage longitudinal tels que l'AIN, le ZnO).

De plus, la présente invention permet une mesure fréquentielle différentielle, connue pour être immune aux effets paramétriques corrélés (les deux modes de la structure sont également affectés par les perturbations thermiques, les vibrations, etc.).

Enfin, la versatilité de la présente solution la rend réellement compétitive et polyvalente face aux modalités réduites offertes par les lignes à retard et la mesure d'une fréquence est notablement plus aisée et précise que celle d'un temps de vol.

En effet, pour une mesure de temps vol bien définie, il faut que les transducteurs soient le plus large bande possible pour que la réponse temporelle correspondante soit la plus courte possible.

La seule bande ISM permettant une telle application est celle centrée en 2,45 GHz. Il est nécessaire de mesurer des retards de l'ordre de la microseconde. Cette mesure peut être réalisée par comptage qui suppose une horloge haute fréquence stable, mais il est encore possible d'analyser l'évolution du retard de phase correspondant à l'aide d'une électronique adaptée.

Cette mesure de phase implique une ambiguïté liée aux rotations trigonométriques multiples pour une gamme de température donnée. Ainsi, une valeur de phase est multivoque en termes de température. La précision de la mesure dépend essentiellement de la source de fréquence du synthétiseur de signaux d'interrogation qui fournit également la référence de phase si besoin (la fréquence centrale d'émission). Pour une mesure telle que celle-ci, il convient d'émettre en bande directe à 2,45 GHz un pulse couvrant le maximum de la bande permise, soit 80 MHz - en pratique 70 MHz pour ne pas émettre en dehors des limites tolérées - recevoir le signal d'abord amplifié une première fois, le ramener en bande de base (le démoduler de sa porteuse à 2,45 GHz), le réamplifier avant d'en extraire l'amplitude et le gain via une méthode de quadrature.

Il est alors nécessaire d'effectuer une transformée de Fourier (selon l'approche décrite par L. Reindl, Wireless Passive SAW Identification Marks and Sensors, 2nd Int. Symp. Acoustic Wave Devices for Future Mobile Communication Systems, Chiba Univ. 3rd- 5th March, 2004, qui peut servir de base d'argumentaire) afin d'évaluer effectivement les données utiles. La précision de la mesure peut être notablement améliorée en moyennant un grand nombre - 16 minimum - de mesures, et en combinant mesures de temps de vol et de phase.

L'invention sera mieux comprise et d'autres avantages apparaîtront à la lecture de la description qui va suivre donnée à titre non limitatif et grâce aux figures annexées parmi lesquelles :

- la figure 1 schématise un transpondeur selon l'invention ;
- la figure 2 illustre un premier exemple de structure utilisée dans un transpondeur selon l'invention ;
- la figure 3 illustre l'évolution de la bande d'arrêt en fonction de la période du réseau, calcul réalisé en considérant un réseau périodique infini ;

- la figure 4 illustre l'écart de fréquence en fonction du nombre de périodes ;
- la figure 5 illustre le paramètre de réflexion S11 de la structure représentée en figure 2 ;
- la figure 6 illustre le schéma électrique équivalent de la structure illustrée en figure 2 ;
- la figure 7 illustre l'évolution de l'amplitude de l'admittance en fonction de la charge résistive appliquée à la structure illustrée en figure 2 pour une ouverture acoustique de 140 $\lambda$ ;
- la figure 8 illustre l'évolution de l'amplitude de l'admittance en fonction de la charge résistive appliquée à la structure illustrée en figure 2 pour une ouverture acoustique de 40 $\lambda$ ;
- la figure 9 illustre l'évolution de l'amplitude de l'admittance en fonction de la charge capacitive appliquée au transducteur T2 pour une ouverture acoustique de 40 $\lambda$ ;
- la figure 10 illustre l'évolution du différentiel de fréquences F2-F1, en fonction de la valeur de la charge capacitive appliquée dans la structure illustrée en figure 2 ;
- la figure 11 illustre l'évolution de l'amplitude de l'admittance en fonction de la charge capacitive appliquée au transducteur T2 pour une ouverture acoustique de 140 $\lambda$ ;
- la figure 12 illustre une variante de structure de modes couplés d'ondes acoustiques de volume avec couplage transversal, utilisée dans un transpondeur de l'invention ;
- les figures 13a et 13b illustrent l'admittance d'un des deux résonateurs de la structure illustrée en figure 10 et couplée transversalement en fonction des conditions électriques imposées au résonateur associé respectivement en circuit ouvert et en circuit chargé sous 50 $\Omega$ ;
- les figures 14a et 14b illustrent des troisièmes variantes de structure de modes couplés d'ondes acoustiques de volume avec couplage longitudinal, utilisée dans un transpondeur de l'invention ;
- la figure 15 illustre la conductance en fonction de la fréquence d'une structure telle que celle illustrée en figure 14a ;
- la figure 16 illustre une structure à trois transducteurs couplés longitudinalement ;
- la figure 17 illustre la réponse en admittance du premier transducteur d'une structure à trois transducteurs ;
- la figure 18 illustre la réponse en admittance du premier transducteur d'une structure à quatre transducteurs.

De manière connue, le couplage de modes acoustiques de surface ou de volume est largement utilisé pour la réalisation de filtres de bande dans un domaine radio-fréquence étendu (5 MHz - 3 GHz). Le principe consiste à coupler deux résonateurs identiques par une zone étroite au sein de laquelle le recouvrement d'ondes évanescentes des champs émis par les deux dispositifs peut s'établir, créant ainsi des conditions de couplage de mode.

La demanderesse rappelle que les ondes évanescentes apparaissent lors d'un effet de réflexion totale à une interface entre deux milieux et correspondent à des solutions des équations de propagation et de condition aux limites pour lesquelles la densité d'énergie décroît de façon exponentielle en s'éloignant de l'interface dans le milieu adjacent à celui dans lequel ladite réflexion s'opère. Une telle réflexion peut être réalisée en acoustique dans les solides à une interface entre 2 milieux :

- d'impédance acoustique différente pour certaines incidences ;
- de vitesse de propagation telle qu'un effet de guidage s'opère entre deux régions d'un guide d'onde, le milieu de plus grande vitesse étant alors celui dans lequel l'onde se propageant (étant excitée) dans le milieu de plus basse vitesse présente le comportement évanescent ;
- dont l'un au moins est artificiellement modifié par la présence d'un réseau périodique, l'onde incidente à ce milieu se propageant à la fréquence de Bragg, soit pour un nombre d'onde égal à $\pi$ divisé par la longueur d'onde et plus généralement dans la zone spectrale dite de bande d'arrêt du réseau :
- dont l'un au moins est un empilement périodique de matériaux d'impédance acoustique différente, formant ainsi un miroir de Bragg.

La distance de pénétration de l'onde évanescente dans le milieu adjacent à celui où s'opère la réflexion dépend en fait de la longueur d'onde, des propriétés acoustiques du milieu où l'onde évanescente s'établit, de la largeur de la bande d'arrêt dans les milieux périodiques.

Ainsi la structure de la présente invention, permet via ce couplage de transmettre des informations entre les points d'entrée et de sortie de la structure dans une zone spectrale conditionnée par le niveau de couplage entre les modes impliqués et le couplage électromécanique propre de ces modes.

La présente invention propose plus précisément d'exploiter cette propriété de couplage pour traduire un effet physique modifiant les propriétés d'une charge d'impédance variant avec le phénomène perturbant. En effet, les capteurs passifs à ondes élastiques de surface ou de volume peuvent être interrogés à distance par des techniques bien établies. Dans le cas d'applications exploitant des résonateurs dans les bandes ISM, la mesure de grandeur électrique (charges capacitive, selfique, mesures On-Off) constitue une gamme de problèmes difficiles à résoudre avec les dispositifs habituels si l'on veut réaliser une mesure fiable, précise et répétable.

Pour y répondre, on peut recourir à deux résonateurs dissociés dont l'un ne sert que de référence, le second étant câblé avec le corps d'épreuve dont les variations de propriétés électriques entraînent des variations des conditions de résonance.

Dans la présente invention, un seul et unique composant exploitant les modes couplés évoqués ci-dessus, permet une mesure différentielle des variations de propriétés du corps d'épreuve associé.

L'invention permet ainsi de réaliser des composants plus compacts, fiables, auto-référencés, et pouvant éventuellement permettre un codage de l'information.

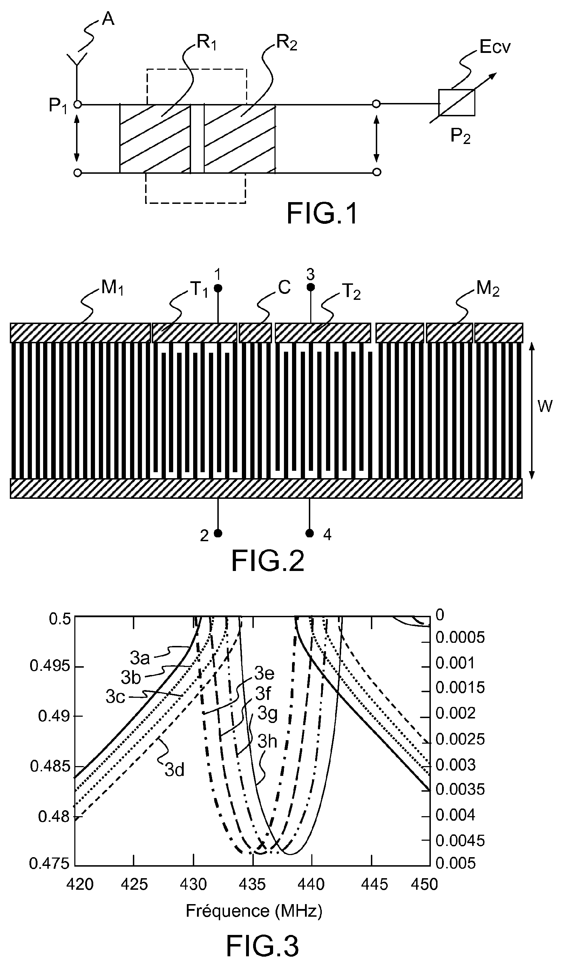

La figure 1 schématise un transpondeur selon l'invention comportant deux résonateurs couplés R1 et R2, reliés respectivement à un premier port P1 et à un second port P2, le second port étant relié à un élément de charge variable Ecv, le premier port étant relié par exemple à une antenne A.

Exemple de réalisation de transpondeur comportant une structure de résonateurs couplés à ondes acoustiques de surface :

L'exemple ci-après illustre le cas d'une structure de type LCR correspondant à l'acronyme de « longitudinally coupled resonator filters » pour définir un couplage de modes résonants de direction de propagation parallèle aux électrodes, réalisée sur quartz. Il pourrait tout aussi bien s'agir d'une structure de type LCR sur langasite, tantalate de lithium, niobate de lithium ou film minces de AlN ou ZnO déposés sur silicium par exemple.

On réalise des fonctions de transductions et de miroirs telles qu'illustrées en figure 2, avec un premier transducteur T1 inséré entre un premier réflecteur M1 et une cavité C, et un second transducteur T2 inséré entre la cavité C et un second réflecteur M2, l'ouverture acoustique W étant de 140 $\lambda$.

De manière générale, la valeur de l'ouverture acoustique conditionne la valeur de capacité statique du transducteur et permet donc de définir la gamme de mesure visée. On peut ainsi ajuster la capacité statique du transducteur pour la rendre sensible à la gamme de variations que l'on souhaite, en tenant compte par la suite du comportement final du composant dans son système de mesure.

Les périodes des transducteurs et des réflecteurs sont choisies de sorte que les ondes sous les réseaux réflecteurs présentent un caractère évanescent.

Avantageusement, on choisit les périodes des réflecteurs de sorte que la partie imaginaire du nombre d'onde normalisé correspondant coïncidant avec la fréquence de synchronisme des transducteurs soit maximale.

Dans le cas de la coupe de quartz (YX*l*)/36° (notation IEEE, Std-176, révision 1949), cette fréquence de synchronisme correspond à l'entrée de la bande d'arrêt. Soit une période de 3,56$\mu$m pour les transducteurs et une épaisseur de métallisation relative voisine de 3,5% (équivalent à une épaisseur absolue de 250 nm) et un rapport de métallisation de 0,7 (soit une largeur d'électrode proche de 2,49 $\mu$m), donnant ainsi lieu à l'excitation d'une onde de longueur caractéristique 7,12$\mu$m (longueur d'onde $\lambda$ égale à deux fois la période).

On peut montrer qu'idéalement, la période des réflecteurs est choisie aussi proche de 3,59 $\mu$m que possible ($\pm$ 0,03$\mu$m). Cette valeur doit être ajustée en fonction des points de fonctionnement choisis et de la largeur de la bande d'arrêt correspondante. Un tel ajustement nécessite l'utilisation de logiciels de calcul des propriétés des ondes de surface sous réseau d'électrodes tels que présentés dans l'article de S.Ballandras, A. Reinhardt, V. Laude, A. Soufyane, S. Camou, W. Daniau, T. Pastureaud, W. Steichen, R. Lardat, M. Solal, P. Ventura, "Simulations of surface acoustic wave devices built on stratified media using a mixed finite element/boundary integral formulation", J. Appl. Phys., 96, 7731-7741 (2004)], et dans l'article de S. Ballandras, R. Lardat, M. Wilm, Th. Pastureaud, A. Reinhardt, N. Champavert, W. Steichen, W. Daniau, V. Laude, R. Armati, G. Martin, A mixed finite element/boundary element approach to simulate complex guided elastic wave periodic transducers, J. Appl. Phys. 105, 014911 (2009); doi:10.1063/1.3021307].

Dans le cas où la résonance a lieu en sortie de bande d'arrêt (cas de certaines coupes de quartz par exemple), la période des réflecteurs peut ainsi s'avérer plus petite que celle des transducteurs.

Plus précisément, la figure 3 illustre à ce titre l'évolution de la bande de d'arrêt en fonction de la période du réseau, calcul réalisé en considérant un réseau périodique indéfini selon l'approche présentée dans l'article S.Ballandras, A. Reinhardt, V. Laude, A. Soufyane, S. Camou, W. Daniau, T. Pastureaud, W. Steichen, R. Lardat, M. Solal, P. Ventura, "Simulations of surface acoustic wave devices built on stratified media using a mixed finite element/boundary integral formulation".

Plus précisément, les courbes 3a, 3b, 3c et 3d sont respectivement relatives aux parties réelles Re pour des périodes de 3,59 $\mu$m, 3,58 $\mu$m, 3,57 $\mu$m et 3,56 $\mu$m alors que les courbes 3e, 3f, 3g et 3h sont relatives aux parties imaginaires Im pour es périodes de 3,59 $\mu$m, 3,58 $\mu$m, 3,57 $\mu$m et 3,56 $\mu$m.

Il est à noter que la longueur du réseau conditionne directement l'écart entre les fréquences des modes de la structure : plus cette distance est grande, plus l'écart entre lesdites fréquences est petit. Cette distance est donc optimisée en fonction des applications visées et surtout des contraintes imposées par les bandes de fréquence utilisées.

Par exemple, la bande ISM centrée en 434 MHz s'étend sur un domaine fréquentiel de 1,7 MHz. Dans la configuration précédente, à titre d'indication, on peut montrer comment l'écart de fréquence entre les deux modes évolue en fonction du nombre de période dans le réflecteur central. On voir qu'il est ainsi loisible de concevoir un composant selon l'invention avec un écart de fréquence maîtrisé et ce sur toute la bande ISM.

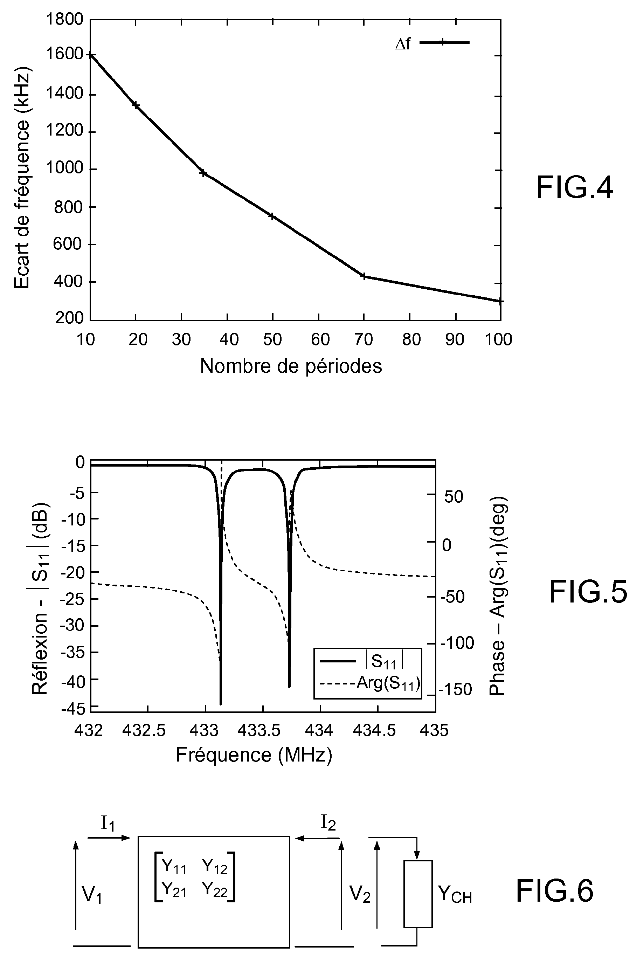

La figure 4 illustre l'évolution de l'écart de fréquence en fonction du nombre de périodes.

Plus précisément, selon un exemple de réalisation, la structure comporte des transducteurs de période égale à 3,56 µm pour une épaisseur de métallisation de 250 nm (h/$\lambda$ = 3,5%), les réflecteurs présentant une période de 3,58 µm, cet écart de période étant fondamental pour le fonctionnement du dispositif.

Le nombre de paires d'électrodes dans les transducteurs T1 et T2 est de 50 (100 doigts), 25 dans la cavité C correspondant au réflecteur central et 400 dans les miroirs M1 et M2 correspondant aux premier et second réflecteurs, conduisant à une longueur totale de dispositif de 3,67mm pour une ouverture de 1 mm, en considérant la propagation sur une coupe de quartz AT, avec un écart entre les deux modes recherchés vers 500 kHz (d'où les 25 électrodes dans la cavité).

La figure 5 montre le paramètre S11 d'un des transducteurs mettant en évidence les deux modes contribuant à la réponse du dispositif quadripolaire (1, 2, 3, 4).

L'influence d'une charge résistive sur l'un des transducteurs du résonateur sur la réponse en réflexion de l'autre transducteur, supposé comme point d'interrogation de la structure a été évaluée. Le schéma électrique équivalent de cette structure est illustré en figure 6.

Dans ce cas, l'admittance du transducteur d'entrée est donnée par la relation (1) où les paramètres $Y_{ij}$ sont relatifs au quadripôle du résonateur, $Y_{Ch}$ représente l'admittance de la charge résistive et $Y'_{11}$ l'admittance équivalente vue au port 1.

$$Y'_{11} = Y_{11} - \frac{Y_{12}Y_{21}}{Y_{Ch}+Y_{22}} \tag{1}$$

On note que pour des cas particuliers, il est possible de montrer l'impact de la charge résistive de façon évidente. En l'occurrence :

- si la charge correspond à un circuit ouvert ($Y_{ch}$=0), on a $Y'_{11}$ = $Y_{11}$-$Y_{12}Y_{21}$/$Y_{22}$ ;
- si la charge correspond à un cas de court-circuit ($Y_{Ch}$= $\infty$) on a $Y'_{11}$ = $Y_{11}$.

Entre ces deux valeurs, on obtient de notables variations de $Y'_{11}$ en fonction de la valeur de $Y_{ch}$.

Ainsi, la sensibilité peut être ajustée en réglant l'impédance du résonateur à la résonance, en jouant sur l'ouverture ou le nombre d'électrodes dans les transducteurs (comme couramment réalisé pour ajuster l'impédance à la résonance de résonateurs dipôles).

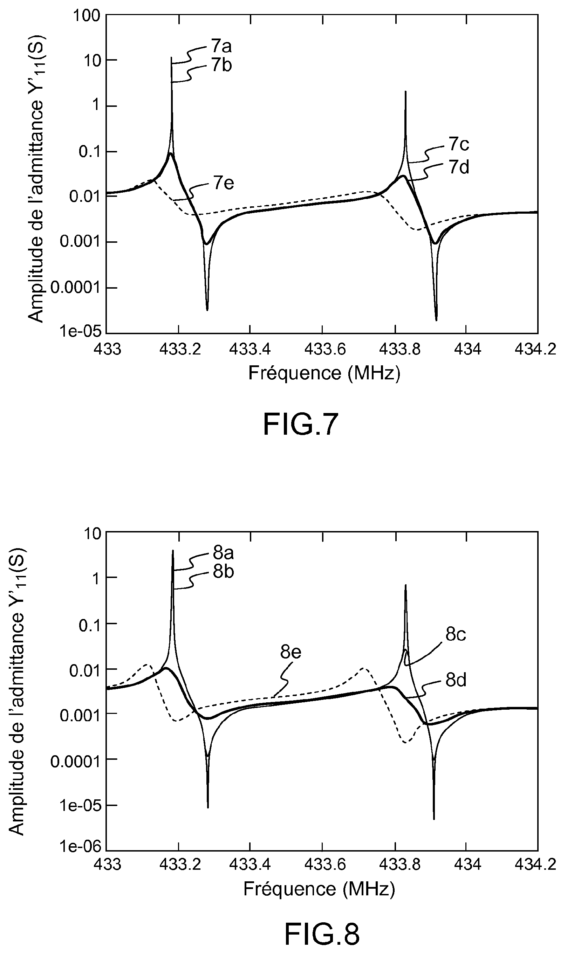

Les figures 7 et 8 montrent l'évolution de l'amplitude de l'admittance en fonction de la charge résistive appliquée sur le transducteur T2 et ce dans le cas d'une couverture acoustique $W_1$ = 140 $\lambda$ et dans le cas d'une ouverture acoustique $W_2$ = 40 $\lambda$.

Plus précisément, les courbes 7a, 8a et 7b, 8b et 7c, 8c et 7d, 8d et 7e, 8e sont relatives respectivement à des impédances de 1M$\Omega$, 100 k$\Omega$, 10k$\Omega$, 1k$\Omega$ et 100$\Omega$.

On voit très nettement le passage à l'accord d'impédance qui fait passer le résonateur d'un état à un autre en terme de fréquence de résonance, avec une très forte variation de l'amplitude de la réponse correspondant à une absorption d'énergie par le dispositif.

Il apparaît que l'ouverture impacte notablement la valeur d'impédance pour laquelle ce changement d'état s'opère (au voisinage de 100 $\Omega$ pour une ouverture de 140$\lambda$ contre 1 k$\Omega$ pour une ouverture de 40$\lambda$.

On peut par ailleurs observer que l'amplitude absolue des pics dépend de la valeur de la charge, mais également l'amplitude relative entre les deux pics, excepté au voisinage de l'accord où ce rapport se stabilise, mais où les pics perdent leur définition spectrale (mesure délicate).

Il apparaît également que la position spectrale relative des pics est modifiée par la charge appliquée, de sorte que l'on puisse déterminer objectivement les états « court-circuit » et « circuit ouvert » tout en effectuant effectivement une mesure et non plus par une simple disparition du signal comme cela était le cas selon l'art connu, qui ne permettait en aucun cas de déterminer le fonctionnement effectif du capteur.

On passe ainsi d'un écart de 650 à 610 kHz quelle que soit l'ouverture acoustique. Cet écart est maximisé par le couplage du mode (écart entre conditions de surfaces libre et métallisée en première approximation), permettant d'envisager des écarts de fréquence plus importants en utilisant des matériaux plus couplés (langasite, tantalate de lithium, niobate de lithium, etc.).

Il est également intéressant d'utiliser un élément de charge de type capacitif et l'on peut modifier les fréquences absolues et l'écart de fréquence des modes par une charge capacitive adaptée à la valeur de capacité, sachant que les valeurs pertinentes sont clairement bornées par les valeurs de capacités statique et motionelle.

En se référant au schéma équivalent de Butterworth-Van Dyke bien connu de l'homme de l'art, un résonateur à base de matériau piézoélectrique peut être représenté par une capacité statique à laquelle est connectée en parallèle une branche dite motionelle, qui correspond aux composants discrets nécessaires à réaliser la fonction de résonance, soit une capacité, une self-inductance et une résistance en série. Ces trois derniers composants virtuels sont en conséquence appelés éléments motionnels, en référence à la vibration dont ils représentent la contribution électrique traduite par l'effet piézoélectrique.

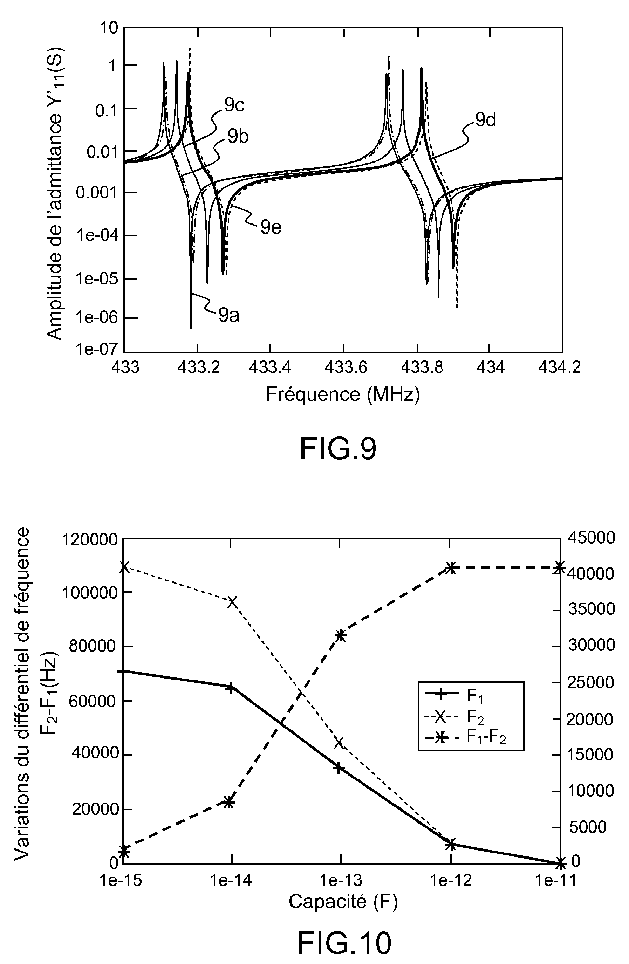

La figure 9 montre les résultats obtenus pour une ouverture de 40λ. On voit que sur une gamme de capacité de 10 pF à 10 fF (respectivement courbes 9a pour un circuit ouvert, 9b pour 10pF, 9c pour 1 pF, 9d pour 100fF, 9e pour 1fF) les fréquences absolues et relatives varient notablement et permettent une mesure directe ou différentielle. La structure est donc bien sensible aux charges réactives.

La figure 10 montre les variations des fréquences et du différentiel. On voit un maximum de sensibilité entre 1pf et 10fF. Ce domaine de sensibilité est réglable bien entendu avec les paramètres du résonateur, en particulier l'ouverture acoustique et le nombre de doigts des transducteurs.

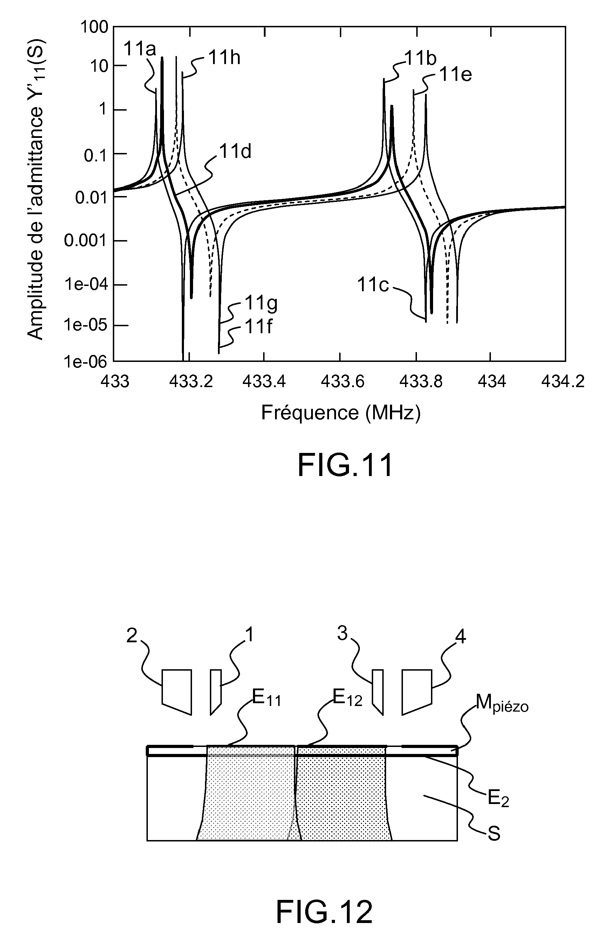

La figure 11 montre l'évolution du spectre en fonction de la charge capacitive pour une ouverture de 140λ.

Plus précisément, la courbe 11a est relative à une capacité infinie (circuit ouvert), la courbe 11 b à une capacité de 1 nF, la courbe 11 c à une capacité de 100pF, la courbe 11 d à une capacité de 10pF, la courbe 11 e à une capacité de 1 pF, la courbe 11 f à une capacité de 100fF, la courbe 11 g à une capacité de 10fF et la courbe 11 h à une capacité de 1 fF.

Il apparaît qu'en jouant sur l'ouverture on conditionne effectivement le point de sensibilité à la charge capacitive optimal. La sensibilité du capteur est en principe dictée par le couplage électrique des modes qui conditionne l'impact de la modification des conditions électriques sur les propriétés de résonance du dispositif. La coupe, le matériau et la nature du mode peuvent donc être des éléments importants d'optimisation de composant.

Exemple de réalisation de transpondeur comportant une structure de résonateurs couplés à ondes acoustiques transverses de volume :

Selon cette variante de l'invention, le transpondeur utilise une structure à ondes de volume réalisée avec une couche de LiNbO3 (Y+36)/LiNbO3 (Y+36) collée par compression de films minces d'or à froid. La plaque de niobate assurant la fonction de transduction présente une épaisseur de $34\mu$m, soit une fréquence du mode fondamental du transducteur seul proche de 110 MHz (pour une vitesse du mode longitudinal de l'ordre de 7000 m.s$^{-1}$), avec des optimums de couplage des modes dits « HBAR » pour « harmonic bulk acoustic resonant » pour les harmoniques impaires de cette même fréquence (300, 500 et 700 MHz pour les harmoniques 3, 5 et 7 respectivement).

Comme illustré en figure 12, une électrode supérieure rectangulaire de $300 \times 200\mu$m$^2$ en aluminium est déposée en surface de la plaque de matériau piézoélectrique $M_{Piézo}$. Elle est gravée en son centre pour donner alors lieu à deux premières électrodes supérieures E11 et E12 séparées d'une bande isolante de $10\mu$m, de dimensions $145 \times 200\mu$m$^2$.

Une électrode de masse E2 est prévue avec retour de cette électrode en face supérieure du substrat, permettant de réaliser effectivement le quadripôle avec les quatre ports 1, 2, 3, 4 comme illustré en figure 10. On définit ainsi deux résonateurs couplés entre respectivement les électrodes $E_{11}$ et $E_2$ et $E_{12}$ et $E_2$.

Avec ce type de structure, il est possible de placer les résonances des deux modes dans une bande de fréquence étroite, comme par exemple les bandes ISM centrées en 434 ou 866 MHz, et d'autant plus facilement dans la bande centrée en 2,45 GHz.

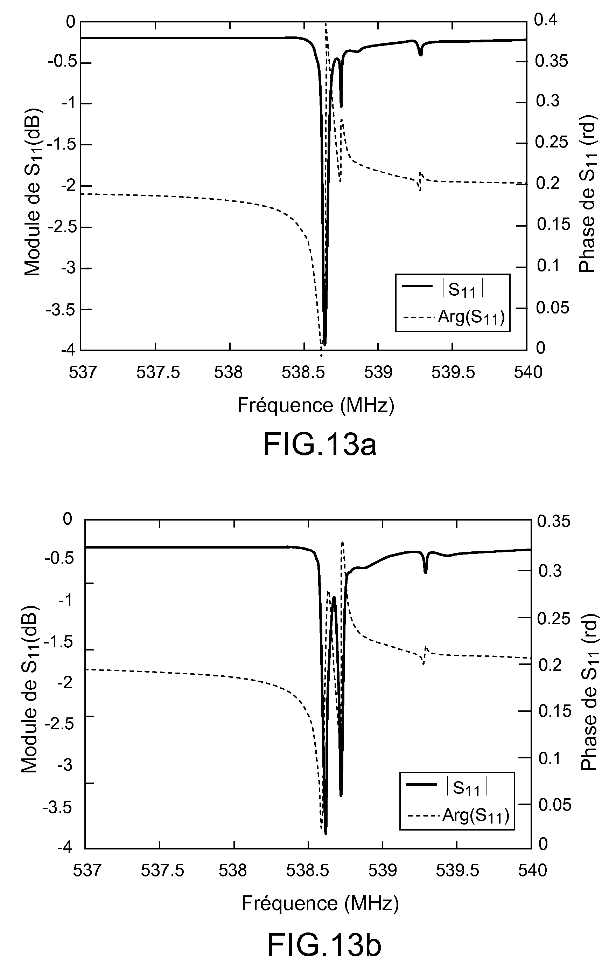

Les figures 13a et 13b illustrent l'admittance d'un des résonateurs en fonction des conditions de charge de son résonateur associé : la première mesure est réalisée en circuit ouvert, c'est à dire que la sortie du quadripôle n'est pas chargée électriquement, la seconde mesure correspond au cas où l'on effectue la mesure de $S_{11}$ en ayant imposé sur le résonateur « de sortie », une charge de 50 Ω.

Il apparaît que la seconde résonance de l'admittance est fortement conditionnée par la charge du résonateur, laissant présumer que l'énergie est alors bien transmise d'un transducteur à l'autre dans la mesure où le système peut effectivement débiter de l'énergie sur une charge.

C'est en effet ce phénomène qui permet une régénération acousto-électrique au niveau du second transducteur : la circulation des charges via une charge d'impédance donnée, entraîne des conditions favorables d'excitation d'une onde dans le second résonateur qui couple son énergie avec le mode du résonateur d'entrée.

Il est à noter que malgré la charge appliquée sur le second résonateur, les deux pics restent toujours nettement résolus et permettent une interrogation a priori aisée du dispositif, soit par voie filaire soit en mode sans fil.

Il apparaît par ailleurs que l'amplitude absolue des deux pics est affectée par la charge, mais également le rapport d'amplitude entre les deux résonances, qui pourrait permettre une analyse plus fine du phénomène perturbant. On note que les fréquences sont par contre peu affectées par la charge appliquée. Pour une charge inductive ou capacitive, on peut s'attendre par contre à un effet de tirage de fréquence modifiant les positions spectrales des résonances.

Ce phénomène peut également être exploité pour remonter à la grandeur perturbant le système.

De même que pour un dispositif SAW, ces dispositifs HBAR voient les résonances couplées selon l'approche proposée dans le brevet affectées par une charge capacitive, résistive ou selfique. On peut dès lors effectuer le même type de mesure que celles montrées pour les résonateurs couplés longitudinalement, avec des sensibilités en rapport du couplage des modes ainsi excités. Si nécessaire, on peut rajouter une simulation illustrant le phénomène mais ce sera en substance le même type de courbes que celles produites pour les SAW.)

Exemple de réalisation de transpondeur comportant une structure de résonateurs couplés à ondes acoustiques longitudinaux de volume :

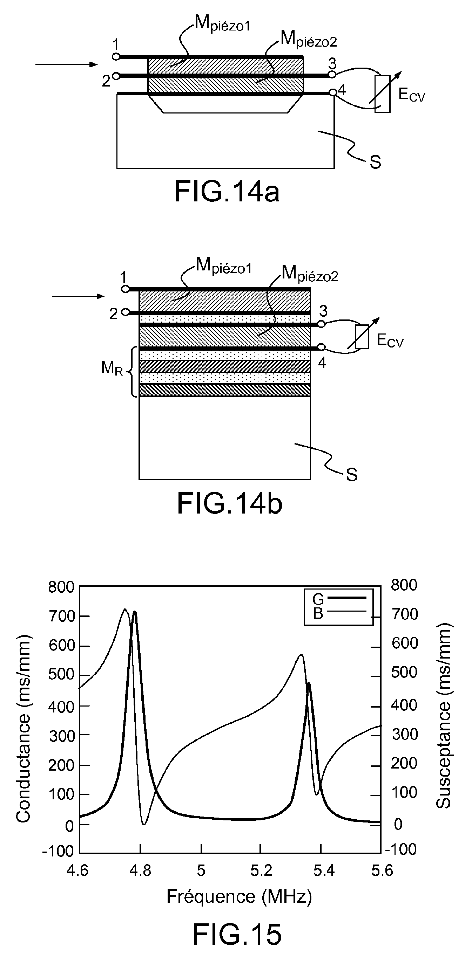

Selon cette variante de l'invention, le transpondeur de l'invention utilise le couplage de modes longitudinaux obtenus à partir de l'empilement de deux structures de résonateurs comportant deux plaques ou films de matériau piézoélectrique $M_{piézo1}$ et $M_{piézo2}$ comme illustré en figure 14a et 14b, respectivement relatives à une structure auto-suspendue sur un substrat S avec des résonateurs couplés directement sans couche de couplage et une structure avec des résonateurs à couche de couplage de type miroir de bragg $M_R$.

Typiquement, le substrat peut être en silicium. Les couches de matériaux piézoélectriques peuvent être réalisées avec le même matériau piézoélectrique et être constituées de films minces d'AlN d'environ $1\mu m$ (correspondant à une épaisseur de $\lambda/2$).

La figure 15 illustre les parties réelles et imaginaires de l'admittance (encore appelées respectivement conductance et susceptance) en fonction de la fréquence de la structure illustrée en figure 14a mettant en évidence l'existence des deux modes couplés.

Selon l'invention proposée ici, un des ports électriques de la structure peut être connectée à un système électrique (mesure filaire) ou à une antenne (interrogation sans fil), l'autre port pouvant être chargé à l'aide d'une charge capacitive, selfique ou résistive permettant comme expliqué plus haut une mesure indirecte de grandeurs physiques modifiant lesdites charges. La charge appliquée audit port électrique peut être complexe (associer des effets réactifs multiples - selfique, résistif et capacitif) dans la mesure où l'on connaît l'évolution de celle-ci selon une ou plusieurs grandeurs physiques perturbant leur fonctionnement.

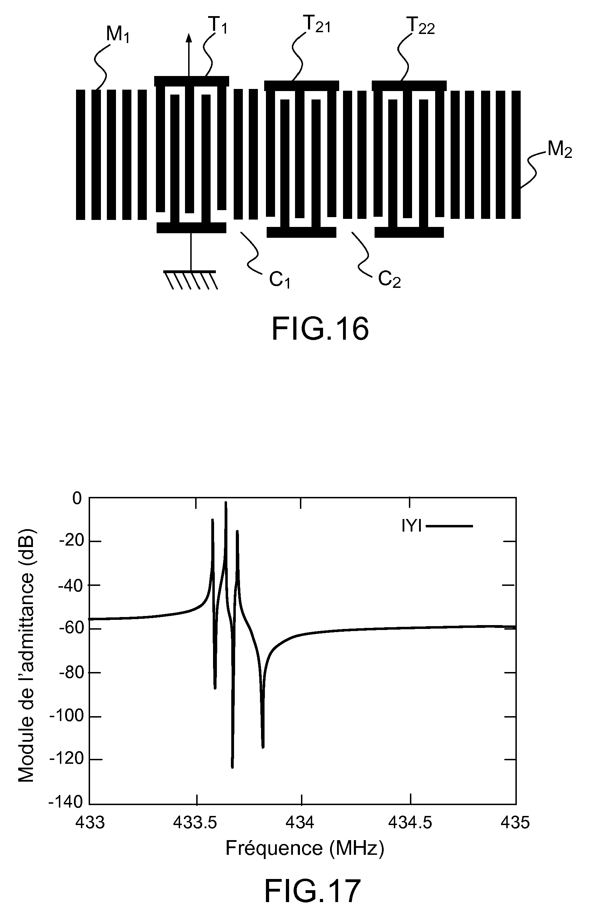

Selon une variante de l'invention, les dispositifs couplés décrits précédemment peuvent être composés de plus de deux transducteurs, le premier transducteur remplissant toujours son rôle de point d'entrée permettant l'interrogation ou la mesure électrique du dispositif en modes filaire et sans fil. La réponse du dispositif fait alors apparaître autant de pics que de transducteurs couplés. Cette variante est illustrée en figure 16.

Le dispositif considéré est ici composé de trois transducteurs $T_1$, $T_{21}$ et $T_{22}$ placés sur une même direction de propagation des ondes, séparés l'un l'autre par un réseau réflecteur comprenant trente électrodes connectées à la référence électrique. Dans l'exemple proposé ici, le pas des transducteurs est de 3,37 $\mu$m, celui des réflecteurs est de 3,55 $\mu$m, le rapport de métallisation étant fixé à 0,7. L'épaisseur d'électrode est de 450 nm, correspondant à une épaisseur relative (épaisseur de métal divisé par la longueur d'onde acoustique égale à deux fois le pas du réseau) dans les transducteurs et les réflecteurs de 6,34 et 6,68% respectivement. Le dispositif est entouré de part et d'autre de réseaux réflecteurs $M_1$ et $M_2$, une cavité $C_1$ et $C_2$ séparant respectivement les transducteurs $T_1$ et $T_{21}$ et $T_{21}$ et $T_{22}$.

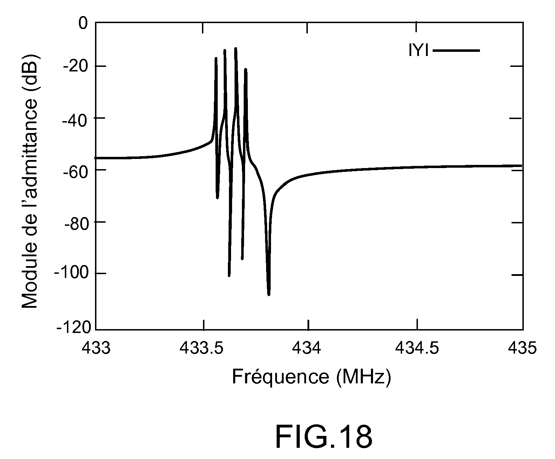

On montre en figure 17 la réponse en admittance du premier transducteur d'une structure à 3 transducteurs, et en figure 18, la réponse en admittance du premier transducteur d'une structure à 4 transducteurs.

On montre qu'il est ainsi loisible de réaliser un code binaire résolu dans l'espace fréquentiel. On peut moduler cette réponse en jouant sur la charge appliquée à chaque transducteur pour modifier ladite réponse, on peut également par conception positionner les résonances de façon à réaliser le code binaire mentionné plus haut.

**Revendications**

1. Transpondeur comportant au moins :

   - un premier résonateur ($R_1$) présentant au moins un premier mode résonant ;
   - un second résonateur ou une série de seconds résonateurs ($R_2$) présentant au moins un second mode résonant ;
   - lesdits premier et second(s) résonateurs étant couplés par une zone étroite au sein de laquelle le recouvrement d'ondes évanescentes des champs émis par les premier et second(s) résonateurs peut s'établir, créant ainsi des conditions de couplage par ondes évanescentes des au moins premier et second modes dans ladite zone étroite;
   - ledit premier résonateur étant connecté via un premier port, à un premier moyen permettant une interrogation (antenne, voie filaire) **caractérisé en ce que** ledit ou lesdits seconds résonateurs sont connectés via au moins un second port, à au moins un élément de charge variable ($E_{CV}$) capable de modifier les conditions de couplage des modes résonants et par voie de conséquence la réponse mesurée sur ledit premier port.

2. Transpondeur selon la revendication 1, **caractérisé en ce qu'**il comporte au moins une structure de résonateurs à ondes acoustiques de surface.

3. Transpondeur selon la revendication 2, **caractérisé en ce que** la structure de résonateurs comporte au moins un premier transducteur positionné entre un premier réflecteur et un réflecteur central, un second transducteur positionné entre ledit réflecteur central et un réflecteur miroir, le long d'un axe longitudinal, de manière à créer de modes acoustiques résonants couplés longitudinaux dont le vecteur propagation est colinéaire audit axe longitudinal.

4. Transpondeur selon la revendication 3, **caractérisé en ce que** la structure de résonateurs est de type symétrique comportant au moins un premier transducteur central et un second transducteur scindé en deux parties positionnées de part et d'autre du premier transducteur, lesdits transducteurs étant situés entre des réflecteurs.

5. Transpondeur selon l'une des revendications 3 ou 4, **caractérisé en ce que** la structure de résonateurs est réalisée à la surface d'un substrat de type quartz ou de type niobate de lithium ou de type tantalate de lithium ou de langasite ou de substrat composite à base de film mince piézoélectrique, avantageusement de l'AlN ou du ZnO sur silicium.

6. Transpondeur selon la revendication 2, **caractérisé en ce que** la structure de résonateurs comporte :

   - une première voie acoustique monomode comprenant au moins un premier transducteur positionné entre deux premiers réflecteurs ;
   - une seconde voie acoustique monomode comprenant au moins un second transducteur positionné entre deux seconds réflecteurs ;
   - les première et seconde voies acoustiques étant couplées de manière à définir des modes acoustiques résonants transversaux se propageant dans une direction parallèle aux voies acoustiques.

7. Transpondeur selon la revendication 6, **caractérisé en ce que** la structure de résonateurs comporte :

   - une première voie acoustique monomode comprenant un premier transducteur positionné entre un premier réflecteur et un premier réflecteur central, un second transducteur positionné entre ledit premier réflecteur central et un second réflecteur ;
   - une seconde voie acoustique monomode comprenant un troisième transducteur positionné entre un troisième réflecteur et un second réflecteur central, un quatrième transducteur positionné entre ledit second réflecteur central et un quatrième réflecteur ;
   - les première et seconde voies acoustiques étant couplées de manière à définir des modes acoustiques résonants transversaux se propageant dans une direction parallèle aux voies acoustiques.

8. Transpondeur selon l'une des revendications 6 ou 7, **caractérisé en ce que** les première et seconde voies acoustiques sont réalisées sur un substrat de type quartz, pouvant être de type coupes de quartz compensées des effets de température (famille de coupes AT, etc.).

9. Transpondeur selon la revendication 1, **caractérisé en ce qu'**il comporte au moins une structure de résonateurs à ondes acoustiques de volume.

10. Transpondeur selon la revendication 9, **caractérisé en ce que** la structure comporte un matériau piézoélectrique inséré entre deux premières électrodes situées dans un même plan, et une seconde électrode, la distance entre lesdites premières électrodes et la seconde électrode étant de l'ordre d'une demi-longueur d'onde acoustique, la longueur d'onde acoustique ($\lambda$) étant égale au rapport de la vitesse du mode sur sa fréquence de résonance, de manière à définir un couplage transversal d'ondes de volume évanescentes.

11. Transpondeur selon la revendication 9, **caractérisé en ce que** la structure comporte un matériau piézoélectrique ($M_{piézo}$) à la surface d'un substrat (S), ladite structure comportant en outre deux premières électrodes ($E_{11}$, $E_{12}$) situées dans un même plan et une seconde électrode ($E_2$) enterrée dans le matériau piézoélectrique, la distance entre lesdites premières électrodes et la surface du substrat étant de l'ordre d'une demi-longueur d'onde acoustique, de manière à définir un couplage transversal d'ondes de volume évanescentes.

**12.** Transpondeur selon la revendication 9, **caractérisé en ce que** la structure comporte un matériau piézoélectrique à la surface d'un substrat (S) et aux moins une première électrode dans un premier plan, une seconde électrode dans un second plan et une troisième électrode dans un troisième plan, le premier résonateur étant défini entre les première et seconde électrodes, le second résonateur étant défini entre les seconde et troisième électrodes de manière à définir un couplage longitudinal d'ondes de volume évanescentes, la structure comportant l'empilement de deux structures de résonateurs comportant deux plaques ou films de matériau piézoélectrique ($M_{piézo1}$, $M_{piézo2}$).

**13.** Transpondeur selon l'une des revendications 10 à 12, **caractérisé en ce que** le matériau piézoélectrique est de type niobate de lithium ou tantalate de lithium.

**14.** Transpondeur selon l'une des revendications 1 à 13, **caractérisé en ce que** l'élément de charge est de type capacitif.

**15.** Transpondeur selon l'une des revendications 1 à 13, **caractérisé en ce que** l'élément de charge est de type selfique.

**16.** Transpondeur selon l'une des revendications 1 à 13, **caractérisé en ce que** l'élément de charge est de type ohmique.

**17.** Transpondeur selon l'une des revendications 1 à 16, **caractérisé en ce que** le premier moyen est une antenne.

**18.** Transpondeur selon l'une des revendications 1 à 16, **caractérisé en ce que** le premier moyen est filaire.

**Patentansprüche**

**1.** Transponder, der wenigstens Folgendes umfasst:

- einen ersten Resonator ($R_1$) mit wenigstens einer ersten Resonanzmode;
- einen zweiten Resonator oder eine Serie von zweiten Resonatoren ($R_2$) mit wenigstens einer zweiten Resonanzmode;
- wobei der erste und der zweite Resonator durch eine enge Zone gekoppelt sind, innerhalb derer die Überlappung von evaneszierenden Wellen der von dem ersten und zweiten Resonator ausgesendeten Felder erzielt werden kann, um so Bedingungen zum Koppeln der wenigstens ersten und zweiten Moden in der engen Zone durch evaneszierende Wellen zu erzeugen;
- wobei der erste Resonator über einen ersten Port mit einem ersten Mittel verbunden ist, das eine Abfrage (Antenne, Verdrahtungsweg) zulässt, **dadurch gekennzeichnet, dass** die ein oder mehreren zweiten Resonatoren über wenigstens einen zweiten Port mit wenigstens einem variablen Lastelement ($E_{CV}$) verbunden sind, das die Kopplungsbedingungen der Resonanzmoden und folglich die an dem ersten Port gemessene Reaktion modifizieren kann.

**2.** Transponder nach Anspruch 1, **dadurch gekennzeichnet, dass** er wenigstens eine Struktur von akustischen Oberflächenwellenresonatoren umfasst.

**3.** Transponder nach Anspruch 2, **dadurch gekennzeichnet, dass** die Resonatorstruktur Folgendes umfasst: wenigstens einen ersten Wandler, der zwischen einem ersten Reflektor und einem zentralen Reflektor positioniert ist, einen zweiten Wandler, der zwischen dem zentralen Reflektor und einem Spiegelreflektor entlang einer Längsachse positioniert ist, um longitudinal gekoppelte akustische Resonanzmoden zu erzeugen, deren Ausbreitungsvektor kollinear zu der Längsachse ist.

**4.** Transponder nach Anspruch 3, **dadurch gekennzeichnet, dass** die Resonatorstruktur vom symmetrischen Typ ist und wenigstens einen ersten zentralen Wander und einen zweiten Wandler umfasst, der in zwei Teile unterteilt ist, die auf beiden Seiten des ersten Wandlers positioniert sind, wobei sich die Wandler zwischen Reflektoren befinden.

**5.** Transponder nach Anspruch 3 oder 4, **dadurch gekennzeichnet, dass** die Resonatorstruktur auf der Oberfläche eines Substrats des Quarztyps oder des Lithiumniobattyps oder des Lithiumtantalattyps oder des Langasittyps oder des Typs eines Verbundsubstrats auf der Basis eines dünnen piezoelektrischen Films vorteilhafterweise aus AIN oder ZnO auf Silicium produziert ist.

**6.** Transponder nach Anspruch 2, **dadurch gekennzeichnet, dass** die Resonatorstruktur Folgendes umfasst:

- einen ersten akustischen Monomoden-Kanal, der wenigstens einen ersten Wandler umfasst, der zwischen zwei ersten Reflektoren positioniert ist;
- einen zweiten akustischen Monomoden-Kanal, der wenigstens einen zweiten Wandler umfasst, der zwischen zwei zweiten Reflektoren positioniert ist;
- wobei der erste und der zweite akustische Kanal miteinander gekoppelt sind, um transversale akustische Resonanzmoden zu definieren, die sich in einer Richtung parallel zu den akustischen Kanälen ausbreiten.

7. Transponder nach Anspruch 6, **dadurch gekennzeichnet, dass** die Resonatorstruktur Folgendes umfasst:

- einen ersten akustischen Monomoden-Kanal, der einen ersten Wandler umfasst, der zwischen einem ersten Reflektor und einem ersten zentralen Reflektor positioniert ist, einen zweiten Wandler, der zwischen dem ersten zentralen Reflektor und einem zweiten Reflektor positioniert ist;
- einen zweiten akustischen Monomoden-Kanal, der einen dritten Wandler umfasst, der zwischen einem dritten Reflektor und einem zweiten zentralen Reflektor positioniert ist, einen vierten Wandler, der zwischen dem zweiten zentralen Reflektor und einem vierten Reflektor positioniert ist;
- wobei der erste und der zweite akustische Kanal miteinander gekoppelt sind, um transversale akustische Resonanzmoden zu definieren, die sich in einer Richtung parallel zu den akustischen Kanälen ausbreiten.

8. Transponder nach Anspruch 6 oder 7, **dadurch gekennzeichnet, dass** der erste und der zweite akustische Kanal auf einem Substrat des Quarztyps realisiert sind, der vom Quarzscheibentyp sein kann, der für Temperatureffekte (Familie von AT-Scheiben usw.) kompensiert wird.

9. Transponder nach Anspruch 1, **dadurch gekennzeichnet, dass** er wenigstens eine Struktur von akustischen Volumenwellenresonatoren umfasst.

10. Transponder nach Anspruch 9, **dadurch gekennzeichnet, dass** die Struktur ein piezoelektrisches Material, das zwischen zwei ersten Elektroden eingefügt ist, die sich in derselben Ebene befinden, und eine zweite Elektrode umfasst, wobei der Abstand zwischen den ersten Elektroden und der zweiten Elektrode etwa eine halbe akustische Wellenlänge beträgt, wobei die akustische Wellenlänge ($\lambda$) gleich dem Quotient der Geschwindigkeit der Mode auf ihrer Resonanzfrequenz ist, um eine transverse Kopplung von evaneszierenden Volumenwellen zu definieren.

11. Transponder nach Anspruch 9, **dadurch gekennzeichnet, dass** die Struktur ein piezoelektrisches Material ($M_{piezo}$) auf der Oberfläche eines Substrats (S) umfasst, wobei die Struktur ferner zwei erste Elektroden ($E_{11}$, $E_{12}$), die sich in derselben Ebene befinden, und eine zweite Elektrode ($E_2$) umfasst, die in dem piezoelektrischen Material eingebettet ist, wobei der Abstand zwischen den ersten Elektroden und der Oberfläche des Substrats in der Größenordnung von einer halben akustischen Wellenlänge liegt, um eine transversale Kopplung von evaneszierenden Volumenwellen zu definieren.

12. Transponder nach Anspruch 9, **dadurch gekennzeichnet, dass** die Struktur ein piezoelektrisches Material auf der Oberfläche eines Substrats (S) und wenigstens eine erste Elektrode in einer ersten Ebene, eine zweite Elektrode in einer zweiten Ebene und eine dritte Elektrode in einer dritten Ebene umfasst, wobei der erste Resonator zwischen der ersten und der zweiten Elektrode definiert wird, wobei der zweite Resonator zwischen der zweiten und der dritten Elektrode definiert wird, um eine longitudinale Kopplung von evaneszierenden Volumenwellen zu definieren, wobei die Struktur den Stapel von zwei Resonatorstrukturen umfasst, die zwei Platten oder Filme aus piezoelektrischem Material (Mpiezol, $M_{piezo2}$) umfassen.

13. Transponder nach einem der Ansprüche 10 bis 12, **dadurch gekennzeichnet, dass** das piezoelektrische Material vom Lithiumniobat- oder vom Lithiumtantalattyp ist.

14. Transponder nach einem der Ansprüche 1 bis 13, **dadurch gekennzeichnet, dass** das Lastelement vom kapazitiven Typ ist.

15. Transponder nach einem der Ansprüche 1 bis 13, **dadurch gekennzeichnet, dass** das Lastelement vom selbstinduktiven Typ ist.

16. Transponder nach einem der Ansprüche 1 bis 13, **dadurch gekennzeichnet, dass** das Lastelement vom ohmschen Typ ist.

**17.** Transponder nach einem der Ansprüche 1 bis 16, **dadurch gekennzeichnet, dass** das erste Mittel eine Antenne ist.

**18.** Transponder nach einem der Ansprüche 1 bis 16, **dadurch gekennzeichnet, dass** das erste Mittel verdrahtet ist.

**Claims**

**1.** A transponder comprising at least:

- one first resonator ($R_1$) having at least one first resonant mode;
- one second resonator or a series of second resonators ($R_2$) having at least one second resonant mode;
- said first and second resonators being coupled by a narrow zone, within which the overlapping of evanescent waves of the fields emitted by said first and second resonators can be established, thus creating conditions for coupling said at least first and second modes in said narrow zone by evanescent waves;
- said first resonator being connected via a first port to a first means allowing a poll (antenna, wired path) to be carried out, **characterised in that** said one or more second resonators are connected via at least one second port to at least one variable load element ($E_{CV}$) capable of modifying the coupling conditions of said resonant modes and, as a consequence, the response measured on said first port.

**2.** The transponder according to claim 1, **characterised in that** it comprises at least one structure of surface acoustic wave resonators.

**3.** The transponder according to claim 2, **characterised in that** said resonator structure comprises at least one first transducer positioned between a first reflector and a central reflector, a second transducer positioned between said central reflector and a mirror reflector along a longitudinal axis, so as to create longitudinally coupled resonant acoustic modes, the propagation vector of which is co-linear to said longitudinal axis.

**4.** The transponder according to claim 3, **characterised in that** said resonator structure is of the symmetric type comprising at least one first central transducer and one second transducer split into two parts positioned on either side of said first transducer, said transducers being located between reflectors.

**5.** The transponder according to any one of claims 3 to 4, **characterised in that** said resonator structure is produced on the surface of a substrate of the quartz type or of the lithium niobate type or of the lithium tantalate type or of the langasite type or of a composite substrate based on a thin piezoelectric film, advantageously made of AlN or ZnO on silicon.

**6.** The transponder according to claim 2, **characterised in that** said resonator structure comprises:

- a first single-mode acoustic pathway comprising at least one first transducer positioned between two first reflectors;
- a second single-mode acoustic pathway comprising at least one second transducer positioned between two second reflectors;
- said first and second acoustic pathways being coupled together so as to define transversal resonant acoustic modes propagating in a direction parallel to said acoustic pathways.

**7.** The transponder according to claim 6, **characterised in that** said resonator structure comprises:

- a first single-mode acoustic pathway complising a first transducer positioned between a first reflector and a first central reflector, a second transducer positioned between said first central reflector and a second reflector;
- a second single-mode acoustic pathway complising a third transducer positioned between a third reflector and a second central reflector, a fourth transducer positioned between said second central reflector and a fourth reflector;
- said first and second acoustic pathways being coupled together so as to define transversal resonant acoustic modes propagating in a direction parallel to said acoustic pathways.

**8.** The transponder according to any one of claims 6 or 7, **characterised in that** said first and second acoustic pathways are produced on a substrate of quartz type, which can be of quartz slice type compensated for temperature effects (family of AT slices, etc.).

9. The transponder according to claim 1, **characterised in that** it comprises at least one structure of bulk acoustic wave resonators.

10. The transponder according to claim 9, **characterised in that** said structure comprises a piezoelectric material inserted between two first electrodes located on the same plane and a second electrode, with the distance between said first electrodes and said second electrode being approximately an acoustic half-wavelength, the acoustic wavelength ($\lambda$) being equal to the ratio of the speed of the mode over its resonant frequency, so as to define a transverse coupling of bulk evanescent waves.

11. The transponder according to claim 9, **characterised in that** said structure comprises a piezoelectric material ($M_{piezo}$) on the surface of a substrate (S), said structure further comprising two first electrodes ($E_{11}$, $E_{12}$) located in the same plane and a second electrode ($E_2$) buried in said piezoelectric material, the distance between said first electrodes and the surface of said substrate being approximately an acoustic half-wavelength, so as to define a transverse coupling of bulk evanescent waves.

12. The transponder according to claim 9, **characterised in that** said structure comprises a piezoelectric material on the surface of a substrate (S) and at least one first electrode in a first plane, a second electrode in a second plane and a third electrode in a third plane, said first resonator being defined between said first and second electrodes, said second resonator being defined between said second and third electrodes so as to define a longitudinal coupling of bulk evanescent waves, said structure comprising the stacking of two structures of resonators comprising two plates or films of piezoelectric material ($M_{piezo1}$, $M_{piezo2}$).

13. The transponder according to any one of claims 10 to 12, **characterised in that** said piezoelectric material is of lithium niobate or of lithium tantalate type.

14. The transponder according to any one of claims 1 to 13, **characterised in that** said load element is of capacitive type.

15. The transponder according to any one of claims 1 to 13, **characterised in that** said load element is of self-inductive type.

16. The transponder according to any one of claims 1 to 13, **characterised in that** said load element is of ohmic type.

17. The transponder according to any one of claims 1 to 16, **characterised in that** said first means is an antenna.

18. The transponder according to any one of claims 1 to 16, **characterised in that** said first means is wire-based.

FIG.1

FIG.2

Fréquence (MHz)

FIG.3

FIG.4

FIG.5

FIG.6

FIG.7

FIG.8

FIG.9

FIG.10

FIG.11

FIG.12

FIG.13a

FIG.13b

FIG.14a

FIG.14b

FIG.15

FIG.16

FIG.17

FIG.18

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- DE 19634621

**Littérature non-brevet citée dans la description**

- Wireless Passive SAW Identification Marks and Sensors. **L. REINDL.** 2nd Int. Symp. Acoustic Wave Devices for Future Mobile Communication Systems. Chiba Univ, 03 Mars 2004
- **S.BALLANDRAS ; A. REINHARDT ; V. LAUDE ; A. SOUFYANE ; S. CAMOU ; W. DANIAU ; T. PASTUREAUD ; W. STEICHEN ; R. LARDAT ; M. SOLAL.** Simulations of surface acoustic wave devices built on stratified media using a mixed finite element/boundary integral formulation. *J. Appl. Phys.,* 2004, vol. 96, 7731-7741

- **S. BALLANDRAS ; R. LARDAT ; M. WILM ; TH. PASTUREAUD ; A. REINHARDT ; N. CHAMPAVERT ; W. STEICHEN ; W. DANIAU ; V. LAUDE ; R. ARMATI.** A mixed finite element/boundary element approach to simulate complex guided elastic wave periodic transducers. *J. Appl. Phys.,* 2009, vol. 105, 014911